Europäisches Patentamt

European Patent Office

Office européen des brevets

(11) Publication number: **0 226 517**
**A2**

# EUROPEAN PATENT APPLICATION

(21) Application number: **86402837.8**

(22) Date of filing: **17.12.86**

(51) Int. Cl.⁴: **H 01 L 21/308**
**H 01 L 21/76**

(30) Priority: **18.12.85 US 810956**

(43) Date of publication of application:
**24.06.87 Bulletin 87/26**

(84) Designated Contracting States: **DE FR GB IT NL**

(71) Applicant: **FAIRCHILD SEMICONDUCTOR CORPORATION**
**10400 Ridgeview Court P.O. Box 1500**
**Cupertino California 95014 (US)**

(72) Inventor: **Early, James M.**
**740 Center Drive**
**Palo Alto California 94301 (US)**

(74) Representative: **Monod, Jean-Yves et al**
**SCHLUMBERGER LIMITED 12 Place des Etats-Unis**
**F-92124 Montrouge Cedex (FR)**

(54) **Method for isolating regions of different impurity concentrations in a semiconductor substrate.**

(57) To define the isolation boundary area around an adjacent active area that is to be isolated, an oxide wall is formed at the boundary of an opening provided in a polysilicon mask for the implantation of an impurity into a substrate. The mask is then removed and a photoresist is placed over the substrate and around the oxide wall. The oxide wall is removed, leaving recesses in the photoresist material. Trenches are etched into the substrate in the area underlying the recesses in the photoresist, and then filled with an oxide material to establish the boundary region. An oxide barrier having a relatively planar surface with the substrate and forming a deep isolation barrier between adjacent areas of different impurity concentration is formed without the need for separate, aligned masks.

EP 0 226 517 A2

**Description**

## METHOD FOR ISOLATING REGIONS OF DIFFERENT IMPURITY CONCENTRATIONS IN A SEMICONDUCTOR SUBSTRATE

### BACKGROUND OF THE INVENTION

The present invention is directed to the manufacture of monolithic integrated circuits. and more particularly to the isolation of adjacent areas of different impurity concentration. such as the substrate and wells in CMOS transistor circuits.

In order to isolate adjacent active regions of different impurity concentrations on a substrate. it is common to provide a barrier of an insulating material such as oxide or undoped polysilicon between them. For example, in CMOS transistor circuits, an oxide barrier is typically provided around the p-type well that is diffused into the n-type body, to effectively isolate the NMOS transistor formed in the well from the complementary PMOS transistor in the body, and thereby prevent latch-up. Because of the presence of this barrier, it becomes possible to place the two complementary transistors closer to one another on the substrate, and thereby increase the packing density of transistors on the integrated circuit chip.

In the past, the doping of the substrate to form the well and the formation of the barrier around the well were carried out in separate processing steps that utilized different photomasks to define the well and the barrier, respectively. Because of the relationship of the barrier to the well, the two masks that were used to form these adjacent areas in the substrate necessarily had to be aligned with one another.

The need to utilize plural aligned masks in the manufacture of an integrated circuit chip is undesirable in that it creates extra processing costs, both with respect to the cost of the masks themselves as well as the additional processing steps that are involved. In addition, because of tolerances required in the alignment of the masks, a certain amount of area on the surface of the silicon wafer must be allocated for such tolerances, thereby reducing the packing density of the devices, e.g. transistors, on the chip.

### OBJECTS AND BRIEF STATEMENT OF THE INVENTION

Accordingly, it is a general object of the present invention to provide a novel method for fabricating integrated circuits which eliminates the need for separate. aligned masks to define adjacent active and isolation regions on a chip.

It is a more specific object of the present invention to provide a novel method for fabricating a CMOS circuit in which the well implant and the isolation region are formed with the use of the same mask, and hence self-aligned with respect to one another.

It is another object of the present invention to provide a novel method for fabricating CMOS circuits that enables such a circuit to be produced with a higher density than that available with conventional processing technology.

In accordance with the present invention, these objects and their attendant advantages are achieved by using only one mask to define an active area and the isolation boundary region which surrounds that area. After a layer of polysilicon or other masking material has been provided on a substrate and appropriately etched to provide an opening through which an impurity is implanted into the substrate to form the active area. an oxide wall is formed at the edges of the opening. The remaining masking material is then removed and a photoresist is placed over the substrate and around the oxide wall. The oxide wall is removed, leaving recesses in the photoresist material. Trenches are etched into the substrate in the area underlying the recesses in the photoresist, and then filled with an insulating material to establish the boundary of the active region. Thus, an insulating barrier having a relatively planar surface with the substrate and forming a deep isolation barrier between adjacent areas of different impurity concentration can be formed without the need for separate, aligned masks.

Further features and advantages of the invention are explained in detail hereinafter with reference to a preferred embodiment of the invention illustrated in the accompanying drawings.

### BRIEF DESCRIPTION OF THE DRAWINGS

Figures 1A and 1B are a cross-sectional side view and a schematic circuit diagram, respectively, of a CMOS inverter circuit.

Figures 2-11 sequentially illustrate the process steps that are used to form an oxide barrier between a well and a substrate in a CMOS circuit without the need for separate, aligned masks.

### DESCRIPTION OF THE ILLUSTRATED EMBODIMENT

In the description of a preferred embodiment of the invention that follows hereinafter, specific reference is made to the fabrication of a CMOS circuit. However, it will be appreciated by those having ordinary skill in the art that the practical applications of the principles underlying the invention are not so limited. Rather, the invention can be used to form a self-aligned barrier between any two adjacent regions of different impurity concentrations in an integrated circuit chip.

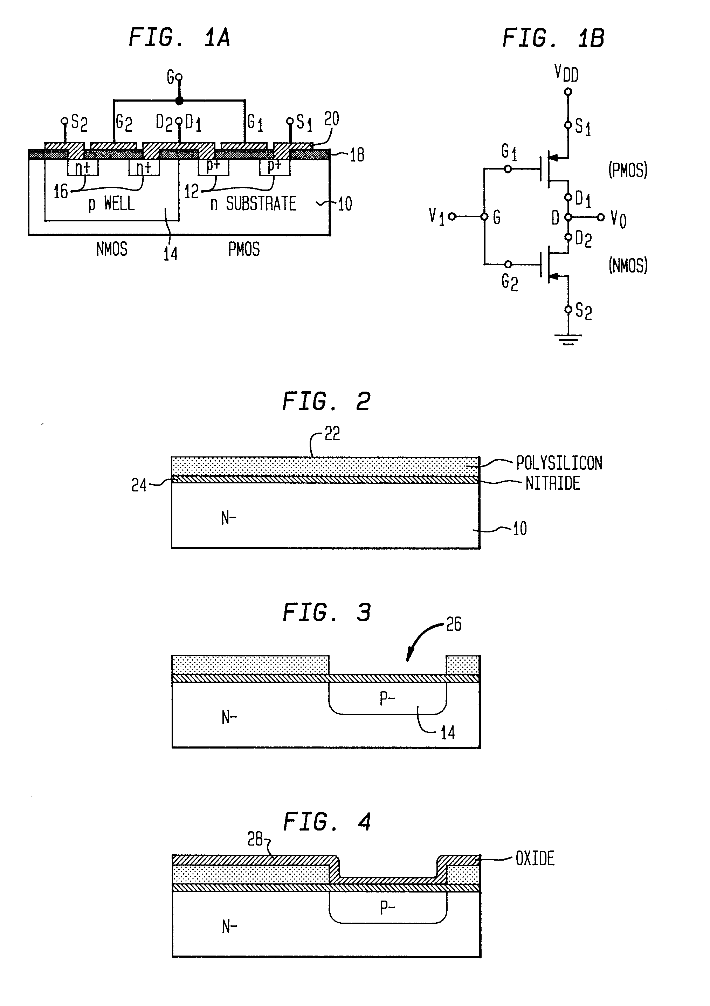

With reference now to a specific technology to which the invention can be applied. a complementary metal-oxide-semiconductor (CMOS) circuit is comprised of pairs of transistors, wherein the two transistors in each pair are of opposite conductivities but formed on the same semiconductor substrate. To provide such a structure, illustrated in Figure 1A, the source and drain electrodes $S_1$ and $D_1$ of one of the transistors, e.g., a PMOS transistor, are directly formed in an n-type substrate 10 by implanting a p-type impurity into two regions 12 of the substrate. To form the other transistor of the complementary pair, e.g., the NMOS transistor, a p-type region, or well 14, is formed in the substrate 10. Then, the source and drain electrodes $S_2$ and $D_2$ of this second transistor are formed by implanting an n-type impurity into two regions 16 of the well. After the substrate has been appropriately doped as shown, a layer of oxide 18 is grown on the substrate. Holes are cut into the oxide layer to provide connections to each of the source and drain electrodes, and a layer 20 of aluminum or other suitable conducting material is used to establish the contacts for these electrodes, as well as form the gate electrodes $G_1$ and $G_2$ of the two transistors. When the gate and drain electrodes of the two transistors are respectively connected together, a CMOS inverter circuit is formed, as schematically illustrated in Figure 1B.

As noted previously, it is a common practice to provide a barrier ring around the p-doped well in order to prevent latchup of the two transistors and enable a higher packing density to be obtained. In accordance with the present invention, this barrier ring is self-aligned with respect to the p-well, i.e. different masks are not required to separately form the barrier ring and the well. Rather, they are both formed using the same mask. The steps for producing such a self-aligned barrier ring in accordance with the present invention are represented in Figures 2-11.

Referring to Figure 2, in order to form the p-doped well in the substrate, a layer 22 of polysilicon or other suitable masking material is provided on the substrate 10. To prevent the undesired growth of oxide in certain areas of the substrate, a layer of silicon nitride 24 can first be deposited on the substrate, as is well known.

The polysilicon masking layer 22 is then etched to form an opening 26 in the region in which the acceptor well is to be formed, as shown in Figure 3. Any suitable donor impurity, such as boron, is implanted into the substrate through the opening 26 defined in the polysilicon mask 22, using any conventional technique, to form the p-type well 14.

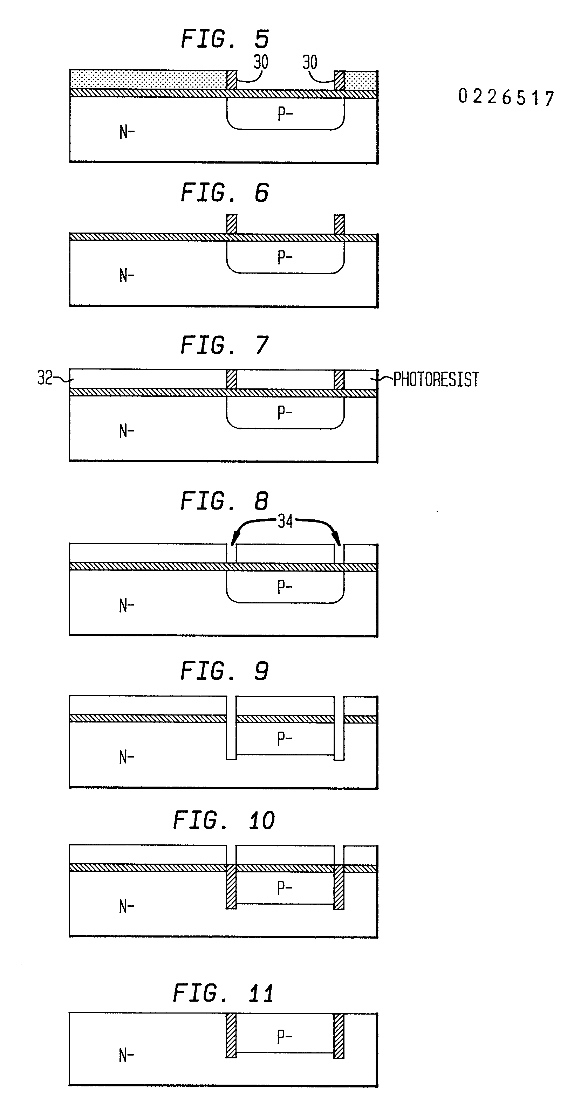

With the polysilicon mask still in place, a layer of oxide 28 is grown over the entire structure, as illustrated in Figure 4, to cover the polysilicon mask as well as the portion of the nitride layer 24 that is exposed through the opening in the mask. This oxide layer is anisotropically etched so as to remove the generally horizontally disposed portions and thereby expose the upper surface of the polysilicon layer 22 and most of the previously exposed portions of the nitride layer 24. However, the vertically oriented portions of the oxide layer that cover the edges of the opening in the polysilicon layer remain, to form an upstanding wall 30 around the boundary of this opening, as shown in Figure 5. The remainder of the polysilicon masking layer 22 is then removed, so that only the upstanding oxide wall 30 remains, as shown in Figure 6.

Referring now to Figure 7, a layer of suitable photoresist material 32 is deposited over the entire structure to a height equal to or exceeding the height of the oxide walls 30. Any other material which is resistant to both silicon and oxide etchants can be used in place of a photoresist to form the masking layer 32. This layer is then etched back so that the tops of the oxide walls are exposed. Using an etching process having a high selectivity for silicon dioxide, the walls are etched out to leave recesses 34 in the photoresist material as shown in Figure 8. Using reactive ion etching, trenches are then cut through the nitride layer and into the silicon substrate to a depth that is preferably slightly greater than the depth of the p-well implant 14.

Referring to Figure 10, the trenches 36 are filled with an oxide or other insulating material 38. The filling of the trenches can be obtained by growing the oxide from the silicon substrate, or by depositing an oxide or a polysilicon material into the trenches, to a height at least equal to that of the nitride layer 24. The photoresist layer 32 is then removed, and the nitride layer is etched away to reveal the surface of the silicon substrate. As can be seen from Figure 11, the insulating barrier that is provided around the p-well implant 14 is substantially coplanar with the silicon substrate.

The remaining implants can then be made to form the source and drain electrodes of the two complementary transistors, and the oxide and metalization layers provided to result in a structure such as that shown in Figure 1A.

From the foregoing, it will be appreciated that the present invention offers a method for isolating adjacent areas of different impurity concentration from one another without the need for plural masking steps. Basically, the same mask that is used to form one of the areas of impurity concentration also defines the outer boundary of the isolation barrier that surrounds this region. Hence, the region and the barrier are self-aligned with respect to one another. This advantage eliminates the needs for separately aligned masks and enables the transistors to be formed on the substrate with a higher packing density than is conventionally available since the need to allocate some portion of the silicon substrate to alignment tolerances is eliminated.

It will be appreciated by those of ordinary skill in the art that the present invention can be embodied in other specific forms without departing from the spirit or essential characteristics thereof. For example, although specifically disclosed with regard to the formation of CMOS circuits, the application of the invention to other integrated circuit technologies will be apparent. The presently disclosed embodiment is therefore considered in all respects to be illustrative and not restrictive. The scope of the invention is indicated by the appended claims rather than the foregoing description, and all changes that come within the meaning and range of equivalence thereof are intended to be embraced therein.

## Claims

1. A process for isolating a predetermined region in a substrate from an adjacent area, comprising the steps of:
coating the substrate with a first layer of masking material and removing the masking material overlying the location of said region to thereby form an opening in said masking material;

forming an oxide wall along the boundary of said opening;

removing the first layer of masking material;

providing a second layer of a masking material on the substrate and around said wall such that the top of said oxide wall is exposed;

removing the oxide wall to thereby form a recess in the second layer of masking material at the location of said oxide wall;

removing a portion of the substrate underlying said complementary recess to thereby form a trench in said substrate; and

filling said trench with an insulating material.

2. The process of claim 1 wherein said first layer of masking material comprises polysilicon.

3. The process of claim 2 further including the step of providing a nitride layer on said substrate prior to the step of coating the substrate with said first layer of masking material.

4. The process of claim 1 wherein said step of forming an oxide wall comprises coating the first layer of masking material and the portion of the substrate exposed through said opening with a layer of oxide material, and anisotropically etching the oxide layer to leave the wall remaining adjacent the boundary of the opening.

5. The process of claim 1 further including the step of doping said region with an impurity subsequent to the formation of the opening in said first layer.

6. The process of claim 1 wherein said second layer of masking material comprises a photoresist.

7. In the manufacture of a CMOS integrated circuit, a method for forming an isolated well in a substrate without the need for plural masks, comprising the steps of:

coating a substrate of one conductivity with a first layer of a masking material;

forming an opening in the layer of masking material;

implanting an impurity of opposite conductivity into the substrate through said opening;

coating the layer of masking material and the opening with a layer of oxide;

anisotropically etching said oxide layer to remove it from the masking layer and the opening except at the boundary of said opening;

removing the layer of masking material;

coating the substrate with a second layer of masking material;

removing the portion of the oxide layer which remained after the anisotropic etching step to thereby form an opening in the second masking layer;

etching a trench into the substrate beneath the opening in said second masking layer; and

filling said trench with an insulating material.

8. The method of claim 7 wherein said first layer of masking material comprises polysilicon.

9. The method of claim 7 wherein said step of coating the substrate with a second layer of masking material comprises depositing a photoresist over the substrate and remaining oxide, and removing some of the photoresist until the top of the remaining oxide is exposed.

10. The method of claim 7 wherein said insulating material comprises an oxide.

11. The method of claim 7 wherein said insulating material comprises polysilicon

0226517

## FIG. 1A

S2 G2 D2 D1 G1 S1 20

G

18

n+ n+ p+ p+

16 12

p WELL n SUBSTRATE 10

NMOS 14 PMOS

## FIG. 1B

V_DD

S1

G1 (PMOS)

V1 G D D1 V0

D2

G2 (NMOS)

S2

## FIG. 2

22

POLYSILICON

24 NITRIDE

N−

10

## FIG. 3

26

P−

N−

14

## FIG. 4

28 OXIDE

P−

N−

0 2 2 6 5 1 7

**FIG. 5**

30    30

P−

N−

**FIG. 6**

P−

N−

**FIG. 7**

32    PHOTORESIST

P−

N−

**FIG. 8**

34

P−

N−

**FIG. 9**

P−

N−

**FIG. 10**

P−

N−

**FIG. 11**

P−

N−